# EUROPÄISCHE PATENTSCHRIFT

(11) **EP 3 682 544 B1**
(45) Veröffentlichungstag und Bekanntmachung des Hinweises auf die Patenterteilung: **16.04.2025**
(21) Anmeldenummer: 18772761.5
(22) Anmeldetag: 07.09.2018
(51) Int. Cl.: H03K 17/955, H03K 17/96, E05F 15/73, G01D 5/24

(54) **KAPAZITIVE SENSORANORDNUNG FÜR EIN FAHRZEUG**
CAPACITIVE SENSOR ASSEMBLY FOR A VEHICLE
ENSEMBLE CAPTEUR CAPACITIF POUR VÉHICULE

(30) Priorität: 14.09.2017 DE 102017121377; 28.03.2018 DE 102018107477
(43) Veröffentlichungstag der Anmeldung: 22.07.2020
(73) Patentinhaber: HUF Hülsbeck & Fürst GmbH & Co. KG, 42551 Velbert (DE)
(72) Erfinder: SIEG, Berthold, 46240 Bottrop (DE); STAHL, Daniel, 31515 Wunstorf (DE)
(74) Vertreter: Bals & Vogel Patentanwälte PartGmbB
(86) Internationale Anmeldenummer: PCT/EP2018/074124
(87) Internationale Veröffentlichungsnummer: WO 2019/052914

(56) Entgegenhaltungen:
- EP-A2- 0 720 327
- DE-U1- 29 721 213
- DE-U1- 29 721 213

## Beschreibung

Die vorliegende Erfindung betrifft eine Anordnung für eine Auswertung bei einer kapazitiven Sensorvorrichtung bei einem Fahrzeug. Ferner bezieht sich die Erfindung auf ein Verfahren zum Betreiben eines Sensorelements, ein Computerprogrammprodukt sowie ein computerlesbares Medium.

Es ist aus dem Stand der Technik bekannt, dass kapazitive Sensoren bei Fahrzeugen zur Detektion einer Aktivierungshandlung vorgesehen sein können. Eine solche Aktivierungshandlung kann dabei als eine einfache Annäherung oder auch als eine komplexe Geste ausgeführt sein. Jedenfalls dient die Aktivierungshandlung zur Aktivierung einer Fahrzeugfunktion, z. B. zur Initiierung einer Authentifizierung bei dem Fahrzeug und/oder zur Öffnung einer Heckklappe. Hierzu kann der kapazitive Sensor im Heckbereich des Fahrzeuges angeordnet sein, bspw. im Bereich eines Stoßfängers, um durch eine Fußbewegung oder dergleichen eines Benutzers des Fahrzeuges aktiviert zu werden.

Eine Auswertung eines kapazitiven Sensors kann durch ein sog. Umladeverfahren erfolgen. Solche Umladeverfahren sind z. B. in der DE 10 2012 102 422 A1, der DE 10 2012 105 266 A1, DE 10 2013 112 909 A1, und der DE 10 2013 112 910 A1 bekannt.

Dabei ist es oft eine technische Herausforderung, Störungen des Sensors durch die Umgebung des Sensors bzw. des Fahrzeuges zu vermeiden. Bekannt ist, dass Feuchtigkeit aus der Umgebung (z. B. Regen) einen Störeinfluss darstellt. Aufgrund der elektronischen Auswertung des Sensors können aber auch elektromagnetische Signale eine Störquelle bilden. So haben z. B. externe Sender, wie ein Mittelwellenrundfunk oder dergleichen, ggf. einen negativen Einfluss. Praktisch relevant sind insbesondere solche Signale dieser Sender, welche bei einer Auswertefrequenz des kapazitiven Sensors wechselwirken, z. B. im Bereich von 510 kHz bis 1,71 MHz. In anderen Worten kann die elektronische Auswertung eine (insbesondere frequenzabhängige) Störsignalsensitivität, vorzugsweise Frequenzsensitivität, aufweisen, sodass bestimmte Frequenzen einen besonderen Störeinfluss darstellen können. Falls diese Signale externer Sender die Auswertung stören, handelt es sich entsprechend um externe Störsignale, welche eine störende Immission für den Sensor des Fahrzeuges darstellen. Maßnahmen zur Reduzierung und/oder Kompensation des Einflusses dieser Störsignale sind dabei technisch aufwendig und kostenintensiv. Ein ähnlicher kapazitiver Sensor ist aus DE29721213 U1 bekannt.

Es ist daher eine Aufgabe der vorliegenden Erfindung, die voranstehend beschriebenen Nachteile zumindest tlw. zu beheben. Insbesondere ist es eine Aufgabe der vorliegenden Erfindung, eine verbesserte Möglichkeit zur Auswertung bei einer kapazitiven Sensorvorrichtung, insbesondere bei einem kapazitiven Sensor, bereitzustellen.

Die voranstehende Aufgabe wird gelöst durch eine Anordnung mit den Merkmalen des unabhängigen Vorrichtungsanspruchs, ein Verfahren mit den Merkmalen des unabhängigen Verfahrensanspruchs, ein Computerprogrammprodukt mit den Merkmalen des nebengeordneten Vorrichtungsanspruchs sowie durch ein computerlesbares Medium mit den Merkmalen des weiteren nebengeordneten Vorrichtungsanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen Verfahren, dem erfindungsgemäßen Computerprogrammprodukt sowie dem erfindungsgemäßen computerlesbares Medium, und jeweils umgekehrt, sodass bezüglich der Offenbarung zu den einzelnen Erfindungsaspekten stets wechselseitig Bezug genommen wird bzw. werden kann.

Die Aufgabe wird insbesondere gelöst durch eine Anordnung, vorzugsweise elektronische Vorrichtung und/oder Schaltungsanordnung, für eine Auswertung bei einer kapazitiven Sensorvorrichtung (vorzugsweise als Annäherungssensor) eines Fahrzeuges. Insbesondere dient die erfindungsgemäße Anordnung zur Detektion einer Aktivierungshandlung beim Fahrzeug.

Das Fahrzeug kann z. B. als ein Kraftfahrzeug, vorzugsweise Personenkraftfahrzeug und/oder Lastkraftfahrzeug ausgeführt sein. Bspw. ist das Fahrzeug als ein Elektrofahrzeug und/oder Hybridfahrzeug und/oder autonomes (selbstfahrendes) Fahrzeug ausgeführt. Das Fahrzeug kann ein Sicherheitssystem aufweisen, welches zur Kommunikation mit einem mobilen Identifikationsgeber (ID-Geber) ausgeführt ist. Über die Kommunikation wird z. B. wenigstens eine Authentifizierungsinformation vom ID-Geber an das Fahrzeug übertragen, wie ein Authentifizierungscode oder dergleichen. Wenn das Sicherheitssystem diese Authentifizierungsinformation auswertet, kann es den ID-Geber authentifizieren und z. B. zur Freigabe und/oder Aktivierung von wenigstens einer Fahrzeugfunktion autorisieren. Bei einem passiven Zugangssystem kann es möglich sein, dass automatisch - ohne manuelle Bedienung des ID-Gebers - bei erfolgreicher Authentifizierung und/oder entsprechender Autorisierung eine Fahrzeugfunktion, wie eine Entriegelung des Fahrzeuges, aktiviert wird.

Mögliche Fahrzeugfunktionen sind bspw. das Entriegeln des Fahrzeuges und/oder das Öffnen einer Heckklappe und/oder das Öffnen einer Seitentür des Fahrzeuges und/oder das Öffnen einer Front- und/oder Motorhaube und/oder das Freigeben eines Motorstarts.

Um den Komfort zu steigern, ist bspw. wenigstens ein Annäherungssensor am Fahrzeug vorgesehen, um bei Detektion der Annäherung eines Objekts und/oder Benutzers (ggf. mit dem ID-Geber) an das Fahrzeug die Kommunikation zur Authentifizierung und/oder zur Aktivierung der wenigstens einen Fahrzeugfunktion zu initiieren. Dieser wenigstens eine Annäherungssensor ist bspw. am Heck- und/oder Seiten- und/oder Frontbereich des Fahrzeuges befestigt. Im Heckbereich kann die Detektion der Annäherung und/oder die erfolgreiche Authentifizierung z. B. das Öffnen der Heckklappe initiieren. Im Frontbereich kann die Detektion der Annäherung und/oder die erfolgreiche Authentifizierung z. B. das Öffnen der Front- und/oder Motorhaube initiieren. Im Seitenbereich kann die Detektion der Annäherung und/oder die erfolgreiche Authentifizierung z. B. das Entriegeln und/oder Öffnen einer Seitentür initiieren.

Gemäß einem weiteren Vorteil der erfindungsgemäßen Anordnung ist der wenigstens eine Annäherungssensor im Heck- und/oder Frontbereich in einem Stoßfänger und/oder im Seitenbereich des Fahrzeuges in einem (Außen-) Türgriff zumindest tlw. angeordnet. Dabei kann es vorgesehen sein, dass wenigstens ein Sensorelement des Annäherungssensors im Stoßfänger bzw. Türgriff angeordnet und auf einen Außenbereich des Fahrzeuges ausgerichtet ist, um so eine Annäherung und/oder Geste in einem Überwachungsbereich außerhalb des Fahrzeuges zu detektieren. Alternativ oder zusätzlich kann der Annäherungssensor auch den Innenbereich des Fahrzeuges überwachen.

Es kann bei Ausführungsvarianten der erfindungsgemäßen Anordnung möglich sein, dass der wenigstens eine Annäherungssensor zumindest tlw. die kapazitive Sensorvorrichtung aufweist oder als diese ausgebildet ist. Als sensitives Element kann der Annäherungssensor, d. h. insbesondere die kapazitive Sensorvorrichtung, wenigstens ein Sensorelement aufweisen. Dieses kann z. B. als Sensorelektrode ausgebildet sein, und derart am Fahrzeug befestigt und/oder ausgerichtet sein, dass ein Überwachungsbereich außerhalb des Fahrzeuges erfasst werden kann. Die Detektion der Annäherung kann ggf. auch dazu genutzt werden, um Gesten oder dergleichen am Fahrzeug zu detektieren. Bspw. können hierzu auch mehrere Sensorelemente für einen gemeinsamen Überwachungsbereich bei der erfindungsgemäßen Anordnung genutzt werden.

Ferner ist eine Kontrollvorrichtung zum Betreiben, insbesondere zur Auswertung, des wenigstens einen Sensorelements mit (unter Nutzung) wenigstens einer (insbesondere elektrischen) Auswertesequenz vorgesehen. Hierbei wird eine (insbesondere elektronische) Ansteuerungsvorrichtung der Kontrollvorrichtung genutzt, um die Auswertesequenz durch eine Anpassung (z. B. als Anpassung der Auswertesequenz und/oder der Auswertung) zur Beeinflussung einer Störsignalsensitivität der Auswertung bei der kapazitiven Sensorvorrichtung, vorzugsweise zur Beeinflussung des Spektrums der Auswertesequenz, bereitzustellen. In anderen Worten kann die Auswertesequenz aufgrund der Anpassung so angepasst sein, dass die Störsignalsensitivität beeinflusst wird. Hierzu kann die Auswertesequenz ggf. wenigstens ein Anpassungsmerkmal aufweisen, welches für die Anpassung spezifisch ist (z. B. Phasensprünge oder dergleichen). Dies hat den Vorteil, dass die Auswertesequenz angepasst sein kann, um den Einfluss von externen Störsignalen bei der Auswertung bei der kapazitiven Sensorvorrichtung zu verringern, und damit die Zuverlässigkeit der Auswertung zu erhöhen.

Gemäß einem Vorteil der Erfindung kann bei der erfindungsgemäßen Anordnung die Anpassung und/oder die Bereitstellung der Auswertesequenz dadurch erfolgen, dass die Auswertesequenz anhand eines Anpassungsmittels erzeugt wird, vorzugsweise gemäß einer Vorgabe (wie einer Vorgabe des zeitlichen Einbringens von Phasensprüngen) und/oder einer vorgegebenen Anpassungsroutine (z. B. einer bestimmten Modulationsart, wie eine Phasenumtastung) erzeugt wird. Hierzu kann bspw. die elektronische Ansteuerungsvorrichtung, wie ein Mikrocontroller oder dergleichen, vorgesehen sein, welche die Erzeugung, ggf. auch eine Signalformung, der Auswertesequenz anhand des Anpassungsmittels durchführt. Das Anpassungsmittel weist bspw. eine vorgespeicherte Information (z. B. in einem Datenspeicher) und/oder ein Computerprogramm und/oder eine Konfiguration der Ansteuerungsvorrichtung auf.

Die Auswertung bei der kapazitiven Sensorvorrichtung dient bspw. zur Durchführung der Detektion einer Annäherung des Objekts und/oder des Benutzers. Wenn durch die Auswertung z. B. eine bestimmte Veränderung einer Eigenschaft des Sensorelements, wie einer veränderlichen Kapazität, festgestellt wird, kann dies als Annäherung interpretiert werden. Hierzu wird z. B. die durch die Auswertung ermittelte Kapazitätsveränderung mit einem Schwellenwert verglichen, um beim Übersteigen des Schwellenwertes die Annäherung positiv zu detektieren. Allerdings kann es möglich sein, dass externe Sender (also Sender außerhalb des Fahrzeuges) externe Störsignale, insbesondere Funksignale, aussenden, welche die Auswertung stören. Diese Störung ist ggf. frequenzabhängig, sodass die Störsignalsensitivität - d. h. insbesondere die Empfindlichkeit für Störsignale - nur für bestimmte Frequenzen oder Frequenzbereiche vorliegt. Um nun die Störsignalsensitivität zu verringern, kann bspw. das Spektrum der Auswertesequenz verändert werden. Bspw. können besonders dominierende oder bestimmte Frequenzen, welche ebenfalls im Störsignal vorhanden sind (also Störfrequenzen), z. B. in einem Ursprungssignal für die Auswertesequenz, abgeschwächt werden. In anderen Worten kann die Anpassung als eine Amplitudenanpassung ausgeführt sein, welche im Ursprungssignal für bestimmte Störfrequenzen die Amplituden abschwächt und/oder im Spektrum umverteilt, um die Auswertesequenz zu erhalten.

Das Ursprungssignal kann bspw. real und/oder analog als Zwischenprodukt elektrisch erzeugt werden, und daraus durch die Anpassung die Auswertesequenz gebildet werden. Es kann aber auch ein fiktives (d. h. gedachtes und/oder nicht elektrisch real und/oder analog erzeugtes und/oder nur digital vorgesehenes) Ursprungssignal sein, welches bei der Signalerzeugung z. B. prozessorintern genutzt wird, um die Auswertesequenz bereitzustellen. Auch kann das (fiktive) Ursprungssignal im Rahmen dieser Erfindung nur zur vereinfachten Veranschaulichung dienen, um die Anpassung zu spezifizieren. Entsprechend kann die Auswertesequenz auch direkt so erzeugt werden, dass es durch die Anpassung beeinflusst ist, ohne dass das Ursprungssignal als solches digital und/oder analog genutzt werden muss. Hierzu ist bspw. die Auswertesequenz durch das Anpassungsmittel vordefiniert und/oder sogar als zeitliche Sequenz (mit den Sequenzanteilen) vorgespeichert, es muss also nicht unbedingt neu generiert, sondern kann lediglich anhand der vorgespeicherten Informationen elektrisch ausgegeben werden (z. B. durch einen Digital-Analog-Wandler). Jedoch kann es vorteilhaft sein, wenn die Auswertesequenz durch das Anpassungsmittel und/oder die Ansteuerungsvorrichtung generiert wird, um bspw. Kosten für einen Datenspeicher zu reduzieren.

Es kann (ggf. unabhängig von der Art der Erzeugung und/oder Generierung und/oder davon, ob das Ursprungssignal tatsächlich bzw. analog genutzt wird) die Auswertesequenz durch die Anpassung spezifiziert sein und insbesondere die Anpassungsmerkmale aufweisen, wie sie durch die Anpassung bewirkt und nachfolgend beschrieben sind. Die Anpassung kann also immer vorgesehen sein, auch bei einer vollständig vorgespeicherten Auswertesequenz, welche lediglich ausgegeben werden muss. Die Nutzung der Anpassung bei der erfindungsgemäßen Anordnung wird dabei vorzugsweise so verstanden, dass sie die Auswertesequenz, insbesondere die Anpassungsmerkmale der Auswertesequenz, spezifiziert. Die Anpassung ist insbesondere als die Erzeugung und/oder Generierung der Auswertesequenz mit einer bestimmten Signalform zu verstehen.

Die Anpassung kann dazu ausgeführt sein, und den Vorteil haben, dass eine Energieverteilung im Frequenzbereich bei der Auswertesequenz umverteilt wird, sodass vorzugsweise eine Art "definiertes Rauschen" entsteht. Ohne die Nutzung der Anpassung, wie z. B. Phasensprünge, wird das Sensorelement z. B. mit einer originären Auswertesequenz (dem Ursprungssignal) betrieben, welche ggf. (im Schwerpunkt bzw. als stärksten Frequenzanteil) eine originäre Auswertefrequenz aufweist. Eine Störquelle in der Umgebung der Sensorvorrichtung, z. B. ein Funksender mit einer Funkfrequenz, welcher der originären Auswertefrequenz zumindest ähnlich ist, kann dann die Auswertung als Störsignal stören, z. B. durch eine Übertragung von Energie auf das Sensorelement. Ziel kann es daher sein, die originäre Auswertefrequenz zu Gunsten der Umverteilung im Spektrum abzuschwächen. Dies kann auch so aufgefasst werden, dass nicht nur eine einzige originäre Auswertefrequenz genutzt wird, sondern stattdessen ein Frequenzbereich. Die einzelne Funkfrequenz hat damit nicht mehr den gleichen störenden Einfluss, und die Auswertung kann verbessert werden.

Die Störsignalsensitivität ist insbesondere eine Sensitivität für Störsignale bestimmter Frequenzen, wobei die Störsignale vorzugsweise extern vom Fahrzeug ausgesendet werden, also Immissionen für die Sensorvorrichtung sind.

Die Auswertesequenz kann ein beliebiges elektrisches Signal sein, vorzugsweise ein rechteckförmiges und/oder rechteckartiges und/oder auf ein Rechteck basierendes Signal (nachfolgend auch kurz: Rechtecksignal) oder ein sinusförmiges und/oder sinusartiges und/oder auf einen Sinus basierendes Signal (nachfolgend auch kurz: Sinussignal), vorzugsweise mit wenigstens einer Frequenz. Bspw. weist das Sinussignal ein schmales Frequenzspektrum auf, wohingegen das Rechtecksignal nicht vernachlässigbare Anteile in einem sehr breiten spektralen Bereich aufweist. Dabei kann das Rechtecksignal (zumindest tlw. oder überwiegend oder im Wesentlichen) aus ungeradzahligen Harmonischen bestehen. Da es sich hierbei selbstverständlich nicht um ideale Signalformen handelt, kann es bei der Auswertesequenz ggf. auch Abweichungen vom vorgenannten geben.

Da die Auswertesequenz bei spektraler Betrachtung ggf. wenigstens eine dominierende Frequenz und/oder wenigstens einen dominierenden Frequenzbereich aufweist, können externe Störsignale z. B. dann die Auswertung störend beeinflussen, wenn diese ebenfalls diese Frequenz und/oder Frequenzanteile in diesem Frequenzbereich haben. Die Auswertung hat also eine Störsignalsensitivität für diese Frequenz und/oder den Frequenzbereich haben. Je höher die Amplitude der Auswertesequenz für diese Frequenz bzw. den Frequenzbereich, umso höher ist ggf. die Störsignalsensitivität dafür. Es kann nun eine Lösung sein, die Störsignalsensitivität der Auswertung durch die Ansteuerungsvorrichtung mittels der Anpassung, vorzugsweise frequenz- und/oder phasenabhängige Anpassung, bevorzugt Frequenz- und/oder Amplituden- und/oder Phasenanpassung, bevorzugt durch eine Modulation, zu beeinflussen. In anderen Worten kann die Auswertesequenz durch diese Anpassung bereitgestellt werden. Hierzu kann z. B. die Amplitude eines Ursprungssignals der Auswertesequenz für wenigstens einen solchen Frequenzanteil verringert werden, welcher einem Frequenzanteil bei dem Störsignal entspricht. In anderen Worten können diejenigen Frequenzen bei der Auswertesequenz abgeschwächt bereitgestellt werden, welche auch im Störsignal vorhanden sind (also wenigstens eine mit dem Störsignal gemeinsame Frequenz). Das Ursprungssignal ist z. B. ein fiktives Signal (z. B. nur zur Verarbeitung genutztes und nicht analog erzeugtes) oder ein zunächst durch die Kontrollvorrichtung analog erzeugtes Signal, welches zur Ausbildung der Auswertesequenz genutzt wird. Bspw. kann das Ursprungssignal ein Rechtecksignal oder Sinussignal mit einem ersten Frequenzspektrum sein, welches durch die Anpassung verändert wird, sodass das angepasste Ursprungssignal die Auswertesequenz mit einem zweiten Frequenzspektrum bildet. Das zweite Frequenzspektrum kann aufgrund der Anpassung einen geringeren und/oder abgeschwächten Anteil der wenigstens einen mit dem Störsignal gemeinsamen Frequenz aufweisen als das erste Frequenzspektrum. Das externe Störsignal wird z. B. durch externe Sender, vorzugsweise Funk- und/oder Radiosender erzeugt. Extern bezieht sich dabei auf das Fahrzeug mit der erfindungsgemäßen Anordnung, das externe Störsignal wird also außerhalb des Fahrzeuges erzeugt und/oder ausgesendet.

Es ist ferner denkbar, dass die Anpassung als eine, insbesondere zeitliche, Anpassung von Sequenzanteilen der Auswertesequenz, vorzugsweise einer Sequenzanteilbreite und/oder eines Sequenzanteilabstands, ausgeführt ist. Hierzu werden bspw. die Sequenzanteilbreite und/oder der Sequenzanteilabstand über die Zeit variiert, um ein Spektrum der Auswertesequenz, insbesondere an ein Störsignal, anzupassen. Auf diese Weise kann zuverlässig die Störsignalsensitivität herabgesenkt werden.

Des Weiteren ist es denkbar, dass die Anpassung als eine Modulation, insbesondere Frequenz- oder Phasenmodulation, ausgeführt ist, sodass wie erfindungsgemäß vorgesehen die Auswertesequenz mit wiederholten Phasensprüngen bereitgestellt wird.

Bspw. kann der Auswertesequenz wenigstens eine originäre Frequenz, vorzugsweise Abtastfrequenz zugeordnet werden. Die originäre Frequenz bzw. Abtastfrequenz ist z. B. eine Frequenz des Ursprungssignals (welches ein einfaches Rechteck- oder Sinussignal sein kann). Die originäre Frequenz ist bspw. der stärkste Frequenzanteil des Ursprungssignals, also des nicht modulierten Signals. Es kann nun möglich sein, dass diese wenigstens eine originäre Frequenz einer Störfrequenz in einem Störsignal entspricht. Daher kann die Auswertung leicht durch Störsignale beeinträchtigt werden, wenn die Auswertesequenz dem Ursprungssignal entsprechen würde. Erfindungsgemäß ist es daher möglich, dass nicht das Ursprungssignal für die Auswertung genutzt wird, sondern eine (ggf. darauf basierende) Auswertesequenz, insbesondere ein Auswertesignal. Dieses weist vorzugsweise (z. B. aufgrund der Modulation ggf. alternativ oder zusätzlich aufgrund weiterer Anpassungsmaßnahmen) ein Spektrum auf, bei welchem die wenigstens eine Störfrequenz des Störsignals (hinsichtlich der Amplitude im Frequenzbereich) abgeschwächt ist. Damit werden die Störsignalsensitivität und somit auch die Zuverlässigkeit der Auswertung verbessert.

Erfindungsgemäß ist vorgesehen, dass die Ansteuerungsvorrichtung dazu ausgeführt ist, die Auswertesequenz mit wiederholten Phasensprüngen zu erzeugen, um vorzugsweise wenigstens eine vorbestimmte Frequenz, bevorzugt eine originäre Abtastfrequenz für das Sensorelement, bei der Auswertesequenz abzuschwächen. Die Phasensprünge sind dabei ein einfaches und zuverlässiges Mittel, um eine Umverteilung der Energie im Spektrum vorzunehmen, also die Amplituden gleichmäßiger auf verschiedene Frequenzen im Frequenzbereich zu verteilten. Daher wird die Störsignalsensitivität für die Störfrequenzen zugunsten der Sensitivität für andere Frequenzen verringert.

Es ist ferner denkbar, dass die Anpassung als eine Frequenzmodulation oder als eine Frequenzumtastung oder als eine Phasenumtastung, vorzugsweise als eine binäre Phasenumtastung oder eine Quadraturphasenumtastung oder eine Phasenumtastung mit wenigstens zwei oder wenigstens vier Phasenzuständen, ausgeführt ist. Diese Methoden eignen sich besonders für die beschriebe Anpassung.

Zudem ist erfindungsgemäß vorgesehen, dass wenigstens ein Schalterelement mit der Ansteuerungsvorrichtung, insbesondere elektrisch, verbunden ist, um wiederholt und in Abhängigkeit von der Anpassung, vorzugsweise in Abhängigkeit von Phasensprüngen, durch die Ansteuerungsvorrichtung geschaltet, vorzugsweise umgeschaltet, zu werden, bevorzugt um so einen Ladungstransport zwischen dem Sensorelement, vorzugsweise einer Sensorelektrode, und der Kontrollvorrichtung gemäß der Auswertesequenz durchzuführen, wobei insbesondere die Auswertesequenz zumindest tlw. durch das Schalten des Schalterelements bereitstellbar ist. Das Umschalten hat den Vorteil, dass in einem ersten Schritt das Sensorelement elektrisch aufgeladen und in einem zweiten Schritt elektrisch ausgewertet werden kann, z. B. durch einen Ladungstransport von dem Sensorelement zu einer Halteanordnung. Da das Umschalten die Auswertesequenz beeinflussen kann, ist es denkbar, dass zur erfindungsgemäßen Anpassung die Ansteuerung des Schalterelements angepasst wird.

Auch ist es optional denkbar, dass die Ansteuerungsvorrichtung dazu ausgeführt ist, die Auswertesequenz mit zumindest tlw. unterschiedlich breit und/oder unterschiedlich beabstandet ausgegebenen Sequenzanteilen, vorzugsweise Pulsen, bevorzugt Rechteck-Pulsen, bereitzustellen. Diese Anpassung im Zeitbereich hat dabei einen direkten Einfluss auf das Spektrum, welches ggf. verbreitert und/oder umverteilt wird.

Des Weiteren ist es im Rahmen der Erfindung optional möglich, dass wenigstens ein Schalterelement mit einem Übertragungspfad zum Sensorelement, insbesondere elektrisch, verbunden ist, um wiederholt das Sensorelement über den Übertragungspfad abwechselnd mit einem Transmit-Pfad (insbesondere zur Aufladung des Sensorelements) und mit einem Receive-Pfad (insbesondere zur Umladung einer Ladung vom Sensorelement) zu verbinden, wobei vorzugsweise zumindest die Umladung und/oder die Aufladung mit der Auswertesequenz durchführbar ist. Zur Umladung ist der Receive-Pfad z. B. mit einer Halteanordnung verbunden. Zur Aufladung ist der Transmit-Pfad z. B. mit einem Digital-Analog-Wandler verbunden. Dies ermöglicht eine einfache und zuverlässige Auswertung.

Es ist ferner denkbar, dass die Kontrollvorrichtung eine Halteanordnung aufweist, welche, insbesondere elektrisch, über einen Receive-Pfad und/oder über ein Schalterelement mit einem Übertragungspfad zum Sensorelement verbunden ist, um vorzugsweise mittels der Auswertesequenz eine Umladung der im Sensorelement gespeicherten Ladung zur Halteanordnung durchzuführen, und bevorzugt um eine veränderliche Kapazität des Sensorelements anhand der Umladung auszuwerten. Hierzu kann eine (insbesondere feste) Kapazität der Halteanordnung genutzt werden, um eine bei der Umladung vom Sensorelement an die Halteanordnung übertragene Ladung zu speichern. Um die Auswertung weiter zu verbessern, kann die Halteanordnung als ein Integrator ausgebildet sein und/oder einen solchen aufweisen.

Gemäß einer vorteilhaften Weiterbildung der Erfindung kann vorgesehen sein, dass die Kontrollvorrichtung dazu ausgeführt ist, das Betreiben, insbesondere die Auswertung, des Sensorelements, insbesondere eine Umladung durch die Auswertesequenz, frequenzsensitiv (insbesondere für externe Störfrequenzen des externen Störsignals) durchzuführen, wobei durch die Anpassung die Störsignalsensitivität verringerbar ist, und vorzugsweise gleichzeitig eine Bandbreite der Frequenzsensitivität erhöhbar ist, wobei bevorzugt die Störsignalsensitivität eine frequenzabhängige Störanfälligkeit für externe (Stör-) Signale bestimmt. Bspw. wird die Störsignalsensitivität dadurch verringert, dass besonders dominierende Frequenzen eines (analogen oder digitalen oder fiktiven, also gedachten) Ursprungssignals abgeschwächt werden und/oder die Amplituden dieser Frequenzen verringert werden. Dies ermöglicht es, dass der Einfluss einzelner besonders dominierender Frequenzen verringert wird, sodass das Störsignal einen verminderten Einfluss auf die Auswertung hat.

Ferner ist es optional vorgesehen, dass die Ansteuerungsvorrichtung ein Anpassungsmittel aufweist, um die Auswertesequenz als ein Signal mit zeitlich aufeinanderfolgenden Sequenzanteilen, insbesondere Pulsen, vorzugsweise in Rechteck- oder Sinusform, zu erzeugen, wobei vorzugsweise durch die Anpassung, bevorzugt durch wiederholte Phasensprünge, sich eine Pulsbreite vereinzelter Pulse oder vereinzelt ein Abstand zwischen den Pulsen sich erhöht, vorzugsweise verdoppelt, insbesondere durch eine Umschaltung zwischen wenigstens oder genau zwei Phasenlagen des Signals bei jedem Phasensprung. Dies stellt eine einfache und kostengünstig umzusetzende Lösung dar, um die beschriebene Anpassung vorzugnehmen.

Ferner kann es im Rahmen der Erfindung vorgesehen sein, dass die Auswertesequenz während des Betreibens durchgehend mittels Phasensprüngen phasenmoduliert bereitstellbar ist, vorzugsweise mittels einer binären Phasenumtastung oder einer Quadraturphasenumtastung oder einer Phasenumtastung mit wenigstens zwei oder wenigstens vier Phasenzuständen. Bei vier Phasenzuständen kann z. B. eine Quadraturphasenumtastung genutzt werden. Dies ermöglicht es, zuverlässige und kostengünstig zu implementierende Methoden zur Modulation einzusetzen. Die Modulation kann zur Anpassung z. B. durch die Ansteuerungsvorrichtung, wie einen Mikrocontroller, mittels eines Computerprogramms (bspw. das Anpassungsmittel) durchgeführt werden. Das Computerprogramm kann dann dazu ausgeführt sein, die Auswertesequenz zu formen, welche für die Modulation charakteristische Anpassungsmerkmale aufweist (wie die Phasensprünge und/oder Sequenzanteilabstände und/oder Pulsabstände und/oder Sequenzanteilbreiten und/oder Pulsbreiten und/oder Sequenzanteilamplituden und/oder Pulsamplituden). Anschließend kann diese geformte - lediglich digital als Information und daher nicht als analoges Signal vorliegende - Auswertesequenz mittels eines Digital-Analog-Wandlers in die analoge Auswertesequenz umgewandelt werden.

Im Rahmen dieser Erfindung kann sich die Nutzung der Modulation als Anpassung darauf beziehen, dass Techniken der Modulation entsprechend und/oder zumindest tlw. genutzt werden, um die Auswertesequenz bereitzustellen bzw. zu generieren. Bspw. bedeutet die Nutzung einer Phasenumtastung, dass Phasensprünge entsprechend der Phasenumtastung in der Auswertesequenz erkennbar sind. Die Modulation muss also nicht so verstanden werden, dass eine Datenübertragung (z. B. über Funk) stattfinden muss. Es kann - nur optional - als Zwischenschritt auch ein (analoges oder digitales) Ursprungssignal moduliert werden, um die Auswertesequenz zu erhalten, oder es kann auf diesen Zwischenschritt verzichtet werden, und die Auswertesequenz direkt geformt werden, um die Auswertesequenz durch die Modulation als Anpassung bereitzustellen.

Es kann weiter möglich sein, dass ein Anpassungsmittel, wie ein Computerprogramm und/oder eine Konfiguration und/oder Daten, vorgesehen ist, welches eine Information über die Anpassung aufweist, und vorzugsweise eine Information über Abstände der Phasensprünge aufweist, um insbesondere die Phasensprünge äquidistant in vordefinierten Abständen durchzuführen. Damit kann eine einfache Möglichkeit bereitgestellt werden, die Anpassung zu konfigurieren bzw. zu programmieren. Die Information kann derart ausgeführt sein, dass die Auswertesequenz als eine feste vorgegebene Sequenz (also eine Abfolge von Teilsequenzen, wie Pulsen) erzeugt wird. Alternativ ist es denkbar, dass die Auswertesequenz eine zufällige oder eine pseudozufällige Abfolge von Sequenzanteilen aufweist. Bspw. kann hierzu die Abfolge durch stochastische Methoden durch die Ansteuerungsvorrichtung erzeugt werden. Entsprechend kann es möglich sein, dass ein Anpassungsmittel vorgesehen ist, welches eine Information über Abstände von Phasensprüngen bei der Anpassung aufweist, um die Phasensprünge in unregelmäßigen und/oder pseudozufälligen, vordefinierten Abständen durchzuführen. Dies kann bspw. durch eine entsprechende Programmierung der Ansteuerungsvorrichtung und/oder eines Zufallszahlengenerators ermöglicht werden.

Somit kann vorgesehen sein, dass ein Anpassungsmittel, vorzugsweise ein Zufallszahlengenerator, zur Durchführung von Phasensprüngen bei der Anpassung in zufälligen Abständen ausgeführt ist. Bspw. wird durch das Anpassungsmittel zufällig bestimmt, ob und/oder wann bei der Auswertesequenz der Phasensprung durchgeführt wird. Hierzu gibt es bspw. Randbedingungen, z. B. dass der Phasensprung nur in bestimmten zeitlichen Abständen oder bei und/oder mit bestimmten Phasenlagen durchgeführt werden darf. Auch kann eine Synchronisierung vorgesehen sein.

Ebenfalls Gegenstand der Erfindung ist ein Verfahren nach Anspruch 9 zum Betreiben eines Sensorelements für eine Auswertung bei einer kapazitiven Sensorvorrichtung eines Fahrzeuges, zur Detektion einer Aktivierungshandlung beim Fahrzeug.

Vorteilhafterweise kann bei einem erfindungsgemäßen Verfahren zumindest einer der nachfolgenden Schritte durchgeführt werden, wobei die Schritte bevorzugt nacheinander in der angegebenen Reihenfolge oder in beliebiger Reihenfolge durchgeführt werden, und ggf. auch einzelne Schritte wiederholt werden können:
- Durchführen mehrerer Umladevorgänge bei dem Sensorelement,
- Durchführen einer Auswertung, insbesondere einer veränderlichen Kapazität des Sensorelements, anhand der Umladevorgänge, um eine Umgebung des Sensorelements zu überwachen,
wobei die Umladevorgänge mit einer Auswertesequenz durchgeführt werden, welche eine Anpassung, nämlich wiederholte Phasensprünge, zur Beeinflussung einer Störsignalsensitivität der Auswertung aufweist. Damit bringt das erfindungsgemäße Verfahren die gleichen Vorteile mit sich, wie sie ausführlich mit Bezug auf eine erfindungsgemäße Anordnung beschrieben worden sind. Zudem kann das Verfahren geeignet sein, eine erfindungsgemäße Anordnung zu betreiben.

Bevorzugt kann im Rahmen der Erfindung vorgesehen sein, dass zur Bereitstellung der Auswertesequenz ein Ursprungssignal, vorzugsweise ein Rechteck- oder Sinussignal, durch die Anpassung angepasst wird, vorzugsweise moduliert, bevorzugt frequenz- und/oder phasenmoduliert, wird, besonders bevorzugt durch eine Ansteuerungsvorrichtung einer Kontrollvorrichtung. Das Ursprungssignal kann dabei tatsächlich erzeugt werden (z. B. über einen Digital-Analog-Wandler), und dann angepasst werden, oder es kann nur als Information durch die Ansteuerungsvorrichtung intern verarbeitet werden, um die Auswertesequenz zu erzeugen. Letzteres hat den Vorteil, dass eine schnelle und zuverlässige Erzeugung der Auswertesequenz möglich ist. Das Ursprungssignal kann entsprechend auch als "Ursprungssignalinformation" aufgefasst werden.

Außerdem ist erfindungsgemäß vorgesehen, dass die Umladevorgänge jeweils einen Übertragungsvorgang zum Aufladen des Sensorelements und/oder einen Empfangsvorgang zum Übertragen einer Ladung des Sensorelements an eine Halteanordnung, nämlich eine ntegratoranordnung, aufweisen, wobei durch die Anpassung, nämlich durch die Phasensprünge, die Übertragungs- und/oder Empfangsvorgänge mit unterschiedlichen Abständen zueinander durchgeführt werden. Die unterschiedlichen Abstände, z. B. von Sequenzanteilen zur Aufladung des Sensorelements und/oder Übertragung der Ladung, ermöglichen die Beeinflussung der Störsignalsensitivität und/oder des Spektrums der Auswertesequenz. Die Integratoranordnung ist z. B. als Integrator mittels eines Operationsverstärkers aufgebaut.

Ebenfalls Gegenstand der Erfindung ist ein Computerprogrammprodukt, umfassend Befehle, die bei der Ausführung durch eine Ansteuerungsvorrichtung diese veranlassen, die Schritte eines erfindungsgemäßen Verfahrens auszuführen. Damit bringt das erfindungsgemäße Computerprogrammprodukt die gleichen Vorteile mit sich, wie sie ausführlich mit Bezug auf ein erfindungsgemäßes Verfahren beschrieben worden sind. Zur Durchführung der Umladevorgänge kann das Computerprogrammprodukt z. B. eine Umschaltung eines Schalterelementes durch die Ansteuerungsvorrichtung initiieren.

Ebenfalls Gegenstand der Erfindung ist ein computerlesbares Medium, auf welchem das erfindungsgemäße Computerprogrammprodukt gespeichert ist. Damit bringt das erfindungsgemäße computerlesbare Medium die gleichen Vorteile mit sich, wie sie ausführlich mit Bezug auf ein erfindungsgemäßes Verfahren beschrieben worden sind.

Außerdem unter Schutz gestellt ist ein weiteres Computerprogrammprodukt zur Bereitstellung und/oder Formung und/oder Erzeugung einer Auswertesequenz gemäß einem erfindungsgemäßen Verfahren und/oder für eine Ansteuerungsvorrichtung einer erfindungsgemäßen Anordnung. Zudem unter Schutz gestellt ist ein weiteres computerlesbares Medium, auf welchem dieses weitere erfindungsgemäße Computerprogrammprodukt gespeichert ist

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen jeweils schematisch:
- Figur 1: eine perspektivische Ansicht eines Fahrzeughecks,
- Figur 2: ein Prinzip-Schaltbild einer erfindungsgemäßen Anordnung und
- Figur 3: eine beispielhafte Auswertesequenz.

In den nachfolgenden Figuren werden für die gleichen technischen Merkmale auch von unterschiedlichen Ausführungsbeispielen die identischen Bezugszeichen verwendet.

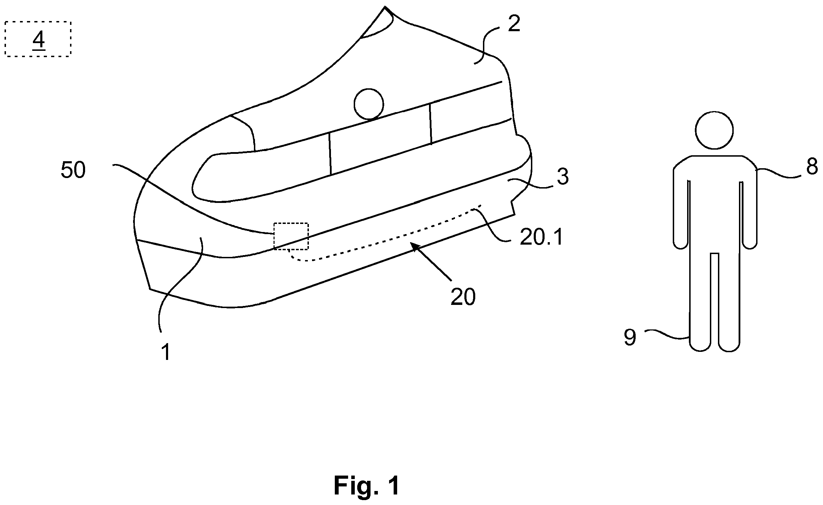

In Figur 1 ist ein Fahrzeug 1 mit einer erfindungsgemäßen Anordnung 10 gezeigt. Die Anordnung 10 ist für eine Auswertung bei einer kapazitiven Sensorvorrichtung 20 des Fahrzeuges 1 ausgeführt, insbesondere zur Detektion einer Aktivierungshandlung beim Fahrzeug 1, z. B. im Front- und/oder Seiten- und/oder Heckbereich. Gezeigt ist beispielhaft für diese Bereiche die Detektion im Heckbereich, bei welcher wenigstens ein Sensorelement 20.1, vorzugsweise wenigstens eine Sensorelektrode 20.1, der erfindungsgemäßen Anordnung 10 in einem Stoßfänger 3 des Fahrzeuges 1 angeordnet sein kann. Auf diese Weise kann die Sensorvorrichtung 20 dazu dienen, einen Außenbereich des Fahrzeuges 1 vor der Heckklappe 2 zu erfassen, um bei Detektion einer Annäherung eines Objektes (wie eines Benutzers 8) eine Fahrzeugfunktion zu aktivieren, wie eine Kommunikation mit einem Identifikationsgeber und/oder eine Öffnung der Heckklappe 2. Bspw. ist das wenigstens eine Sensorelement 20.1 derart angeordnet und auf den Außenbereich ausgerichtet, dass eine Bewegung eines Körperteils 9 als Aktivierungsmittel 9 des Benutzers 8 unterhalb der Heckklappe 2 bzw. unterhalb des Stoßfängers 3 detektiert wird. Alternativ oder zusätzlich kann das Sensorelement 20.1 auch in weiteren Komponenten des Fahrzeuges 1 angeordnet sein, wie in wenigstens einem Türgriff 4, vorzugsweise Außentürgriff 4, und/oder in einem Schweller und/oder dergleichen.

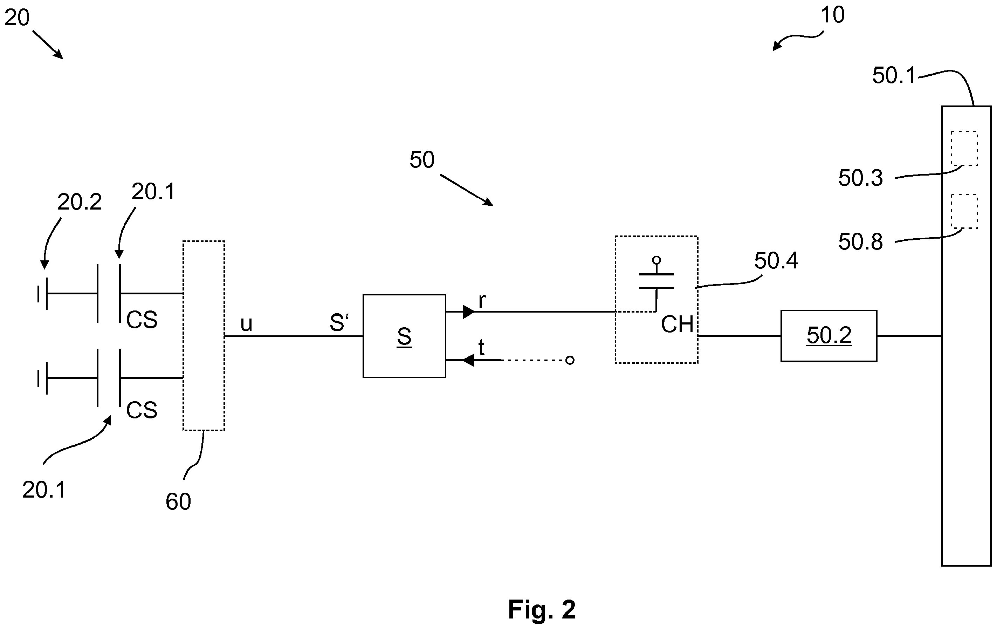

Ferner kann eine Kontrollvorrichtung 50 zum Betreiben des wenigstens einen Sensorelements 20.1 vorgesehen sein. Hierzu kann die Kontrollvorrichtung 50 wenigstens eine Auswertesequenz S' nutzen, wie in Figur 2 schematisch im Schaltbild dargestellt ist. Konkret ist hierbei eine Ansteuerungsvorrichtung 50.1 der Kontrollvorrichtung 50 vorgesehen, um die Auswertesequenz S' durch eine Anpassung zur Beeinflussung einer Störsignalsensitivität der Auswertung, vorzugsweise zur Beeinflussung des Spektrums der Auswertesequenz S', bereitzustellen. Die Ansteuerungsvorrichtung 50.1 ist bspw. als ein Mikrocontroller und/oder integrierter Schaltkreis und/oder Prozessor und/oder dergleichen ausgebildet. Die Ansteuerungsvorrichtung 50.1 und/oder weitere Teile der Kontrollvorrichtung 50 sind vorzugsweise auf einer nicht explizit gezeigten Leiterplatte der Sensorvorrichtung 20 befestigt. Über Leiterbahnen dieser Leiterplatte kann die Kontrollvorrichtung 50, insbesondere die Ansteuerungsvorrichtung 50.1, elektrisch mit dem Sensorelement 20.1 verbunden sein. Möglich sind ggf. aber auch (zumindest tlw.) andere Verbindungsvarianten zum Signaltransport, wie eine galvanisch getrennte und/oder optische Signalübertragung. Auf diese Weise kann die Auswertesequenz S' als ein (bspw. elektrisches) Signal zwischen der Kontrollvorrichtung 50 und dem Sensorelement 20.1 übertragen werden, um das Sensorelement 20.1 und damit die Sensorvorrichtung 20 zu betreiben, insbesondere um eine Erfassung der Sensorvorrichtung 20 auszuwerten und/oder bereitzustellen.

Zum Signaltransport dient vorzugsweise (zumindest tlw.) ein Übertragungspfad u, welcher die Kontrollvorrichtung 50 mit dem wenigstens einen Sensorelement 20.1 verbindet. Es ist in Figur 2 gezeigt, dass wenigstens ein Schalterelement S mit dem Übertragungspfad u zum Sensorelement 20.1 (insbesondere elektrisch) verbunden sein kann, um wiederholt das Sensorelement 20.1 über den Übertragungspfad u abwechselnd mit einem Transmit-Pfad t zur Aufladung des Sensorelements 20.1 und mit einem Receive-Pfad r zur Umladung einer Ladung vom Sensorelement 20.1 zu verbinden, wobei zumindest die Umladung mit der Auswertesequenz S' durchführbar ist. Bspw. kann auch die Aufladung mit der Auswertesequenz S' durchgeführt werden. Die Aufladung betrifft insbesondere einen (elektrischen) Ladungstransport von der Kontrollvorrichtung 50 zum Sensorelement 20.1 und die Umladung einen (elektrischen) Ladungstransport vom Sensorelement 20.1 zur Kontrollvorrichtung 50, vorzugsweise zu einer Halteanordnung 50.4 mit einer Haltekapazität CH. Optional können auch mehrere (zumindest zwei) Sensorelemente 20.1 vorgesehen sein, welche (z. B. abwechselnd und/oder getaktet) über eine Schaltvorrichtung 60 mit dem Übertragungspfad u verbunden werden können. Dies ermöglicht es, die Auswertung mit einer einzigen Kontrollvorrichtung 50 (und/oder auch einzigen Halteanordnung 50.4) aber mehreren Sensorelementen 20.1 durchzuführen.

Die Halteanordnung 50.4 kann (ggf. elektrisch) über das Schalterelement S mit dem Übertragungspfad u zum Sensorelement 20.1 verbunden sein (d. h. auch wiederholt verbunden werden), um mittels der Auswertesequenz S' eine Umladung (insbesondere einen Transport) der im Sensorelement 20.1 gespeicherten Ladung zur Halteanordnung 50.4 durchzuführen, und vorzugsweise um eine veränderliche Kapazität (Sensorkapazität CS) des Sensorelements 20.1 anhand der Umladung auszuwerten. Das Auswerteprinzip kann dabei so verstanden werden, dass die veränderliche Kapazität CS durch das Sensorelement 20.1 bereitgestellt wird, und aufgrund von äußeren Einflüssen (wie einer Annäherung an das Sensorelement 20.1) verändert wird. Bspw. wird die veränderliche Kapazität CS von der Kontrollvorrichtung 50 gegen ein Massepotential 20.2 gemessen, sodass das Sensorelement 20.1 als eine einzige Elektrode (die Sensorelektrode 20.1) ausgeführt sein kann. In anderen Worten muss nicht zwingend eine Gegenelektrode zur Sensorelektrode 20.1 baulich (bspw. als diskretes Bauteil) vorgesehen sein, um die Auswertung der Sensorvorrichtung 20 zu ermöglichen. Bspw. kann das Sensorelement 20.1 als eine einzige elektrische Leitung ausgebildet sein (und sich z. B. länglich in Kabelform erstrecken), welche über eine einzige elektrische Verbindung mit dem Übertragungspfad u verbunden ist. Es ist hierbei ersichtlich, dass bei einem solchen Aufbau die Kapazität CS durch das Sensorelement 20.1 derart gebildet wird, dass die Umgebung des Fahrzeuges die Kapazität CS und damit die Auswertung beeinflusst, insbesondere ein Dielektrikum für diese Kapazität CS bildet. Insbesondere wenn das Sensorelement 20.1 als Elektrode aufgefasst werden kann, wird deutlich, dass elektrische und/oder elektromagnetische Einflüsse außerhalb des Fahrzeuges 1 die Auswertung beeinflussen können. So ist es denkbar, dass externe (d. h. außerhalb des Fahrzeuges 1 befindliche) Sender wenigstens ein Störsignal aussenden können, welches auf die Auswertung einwirkt. Bspw. weist das Störsignal wenigstens eine Frequenz auf, welche auch bei der Auswertesequenz S' genutzt wird. Solche Störfrequenzen können einen nicht zu vernachlässigenden Einfluss auf die Auswertung haben, und die bei der Auswertung gemessene Kapazität und/oder den Ladungstransport verändern (und daher ggf. zu einer fehlerhaften Detektion der Sensorvorrichtung 20 führen). Als Lösung kann daher erfindungsgemäß vorgesehen sein, eine Anpassung zu nutzen, welche das wenigstens eine Störsignal bei der Bereitstellung, insbesondere Erzeugung, der Auswertesequenz S' berücksichtigt. In anderen Worten kann ggf. ein gedachtes oder reales erstes Signal, nachfolgend auch als ein Ursprungssignal bezeichnet, auf das die Auswertesequenz S' basiert, angepasst werden.

Die Auswertesequenz S' weist z. B. wenigstens eine originäre Frequenz, vorzugsweise Abtastfrequenz, für das Sensorelement 20.1 auf, welche wenigstens einer Frequenz im Störsignal (zumindest nahezu oder annähernd) entspricht. Je nach Anpassung weist die Auswertesequenz S' diese originäre Frequenz ggf. auch nicht mehr auf, sondern basiert lediglich darauf (z. B. wurde die Frequenz durch die Anpassung eliminiert). Die originäre Abtastfrequenz ist daher bspw. eine Frequenz des Ursprungssignals (welches ein einfaches Rechteck- oder Sinussignal sein kann). Das Ursprungssignal ist bspw. ein Signal, welches durch einen einfachen Taktgenerator erzeugt werden kann. Wenn hierbei feste Frequenzen für das Ursprungssignal vorgesehen sind, kann die Auswertung leicht durch Störsignale beeinträchtigt werden, wenn die Auswertesequenz S' dem Ursprungssignal entsprechen würde. Daher kann das Ursprungssignal angepasst werden, um daraus die Auswertesequenz S' mit einem veränderten Spektrum zu erhalten. Auf diese Weise kann das Spektrum angepasst werden, um unempfindlicher gegenüber dem Störsignal zu sein. Es kann also die Störsignalsensitivität der Auswertung herabgesenkt werden.

Die Anpassung ist bspw. als eine Modulation, insbesondere Frequenz- oder Phasenmodulation, (insbesondere des Ursprungssignals) ausgeführt. Es kann also eine Methode genutzt werden, welche zur Durchführung einer Modulation bekannt ist, um die Auswertesequenz S' angepasst bereitzustellen. Solche Methoden sind bspw. eine Frequenzmodulation und/oder eine Frequenzumtastung und/oder eine Phasenmodulation und/oder eine Phasenumtastung. Die Nutzung solcher Methoden hat den Vorteil, dass die Störfestigkeit der Auswertung gegenüber dem Störsignal erhöht werden kann, da die Frequenzanteile der Auswertesequenz S' abgeschwächt werden können, die auch im Störsignal vorhanden sind. Das Prinzip wird nachfolgend anhand von Beispielen näher erläutert.

Die Anpassung erfolgt bevorzugt derart, dass die Auswertesequenz S' mit wiederholten Phasensprüngen P bereitstellbar ist. Entsprechend kann die Ansteuerungsvorrichtung 50.1 dazu ausgeführt sein, die Auswertesequenz S', insbesondere mit wiederholten Phasensprüngen P, zu erzeugen, um wenigstens eine vorbestimmte Frequenz, vorzugsweise eine originäre Abtastfrequenz für das Sensorelement 20.1, bei der Auswertesequenz S' abzuschwächen. Hierzu kann die Modulation genutzt werden, z. B. eine Phasenumtastung, welche vorzugsweise als eine binäre Phasenumtastung oder eine Quadraturphasenumtastung oder eine Phasenumtastung mit wenigstens zwei oder wenigstens vier Phasenzuständen, ausgeführt ist.

Um die Anpassung zu realisieren, kann das wenigstens eine Schalterelement S mit der Ansteuerungsvorrichtung 50.1 elektrisch verbunden sein, damit das Schalterelement S wiederholt und in Abhängigkeit von der Anpassung, vorzugsweise in Abhängigkeit von Phasensprüngen P, durch die Ansteuerungsvorrichtung 50.1 geschaltet, vorzugsweise umgeschaltet, wird. Auf diese Weise kann ein Ladungstransport zwischen dem Sensorelement 20.1 und der Kontrollvorrichtung 50 gemäß der Auswertesequenz S' durchgeführt werden, wobei die Auswertesequenz S' zumindest tlw. durch das Schalten des Schalterelements S bereitstellbar ist. Bspw. wird das Schalterelement S zur Durchführung der Anpassung unregelmäßig umgeschaltet, um so die Störsignalsensitivität bei der Auswertung zu verringern. Das Umschalten kann ein Umschalten zwischen dem Receive-Pfad r und dem Transmit-Pfad t sein, welche hierdurch abwechselnd mit dem Übertragungspfad u verbunden werden.

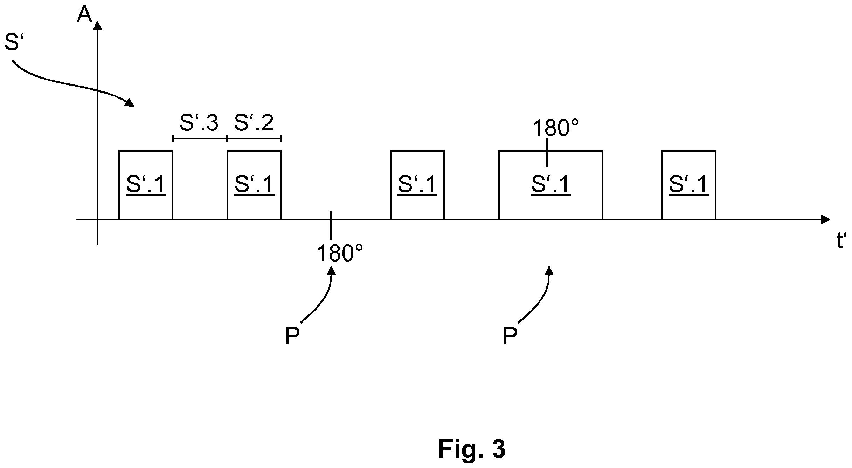

Wie in Figur 3 dargestellt ist, kann die Ansteuerungsvorrichtung 50.1 dazu ausgeführt sein, die Auswertesequenz S' mit zumindest tlw. unterschiedlich breit und/oder unterschiedlich beabstandet ausgegebenen Sequenzanteilen S'.1, vorzugsweise Pulsen, bevorzugt Rechteck- und/oder signalförmige Pulsen, bereitzustellen. Die Sequenzanteile S'.1 sind im Ursprungssignal bspw. in regelmäßigen Abständen vorhanden, und das Ursprungssignal hat daher ein Spektrum mit wenigstens einer dominierenden Frequenz. Dies macht die Auswertung ggf. anfällig für Störsignale, welche ebenfalls diese Frequenz als Störfrequenz aufweisen. Da erfindungsgemäß nicht das Ursprungssignal, sondern (bspw. ausschließlich) die Auswertesequenz S' zur Auswertung genutzt wird (das Ursprungssignal wird z. B. gar nicht erst erzeugt oder lediglich intern als digitales "Zwischenprodukt" in der Ansteuerungsvorrichtung 50.1), kann die Störsignalsensitivität wie gewünscht beeinflusst werden. Durch die Nutzung der Anpassung können bspw. Abstände und/oder Breiten der Sequenzanteile S'.1 verändert werden. Beispielhaft dargestellt sind Sequenzanteilbreiten S'.2 und Sequenzanteilabstände S'.3, welche durch Phasensprünge P über die Zeit t' variiert werden. Eine Phasenlage ist zur Verdeutlichung ebenfalls beispielhaft eingezeichnet. So kann der erste Phasensprung P bei 180° erfolgen, und den Sequenzanteilabstand S'.3 vergrößern. Ferner kann der nächste zweite Phasensprung P die Sequenzanteilbreite S'.2 vergrößern. Auf diese Weise kann durch die Anpassung der Sequenzanteile S'.1 (ggf. bei nicht veränderter Amplitude A) im Zeitbereich (wie in Figur 3 dargestellt) das Spektrum der Auswertesequenz S' und damit die Amplitude A (im Frequenzbereich) für bestimmte Frequenzanteile an das Störsignal angepasst (im Hinblick auf das Störsignal geändert) werden. Hierzu kann z. B. ein Anpassungsmittel 50.3, wie ein Computerprogramm und/oder ein Zufallszahlengenerator, der Ansteuerungsvorrichtung 50.1 genutzt werden. Die Anpassung kann bspw. auch eine vorgespeicherte Information und/oder Sequenz für die Auswertesequenz S' nutzen, welche bspw. in einem Datenspeicher 50.8 der Ansteuerungsvorrichtung 50.1 gespeichert ist. Alternativ oder zusätzlich kann ein Datenspeicher 50.8 der Ansteuerungsvorrichtung 50.1 auch als computerlesbares Medium für das Computerprogramm genutzt werden. Zur Ausgabe der Auswertesequenz S', insbesondere des in Figur 3 gezeigten Auswertesignals S', kann ein Digital-Analog-Wandler 50.2 genutzt werden, welcher z. B. in der Ansteuerungsvorrichtung 50.1 integriert sein kann. Auf diese Weise kann zuverlässig die Ansteuerungsvorrichtung 50.1 und/oder das Anpassungsmittel 50.3 genutzt werden, um die Auswertesequenz S' als ein Signal S' mit zeitlich aufeinanderfolgenden Pulsen (d. h. den Sequenzanteilen S'.1), insbesondere in Rechteck- oder Sinusform, zu erzeugen, wobei durch die Anpassung, vorzugsweise durch wiederholte Phasensprünge P, sich eine Pulsbreite (d. h. Sequenzanteilbreite S'.2) vereinzelter Pulse oder vereinzelt ein Abstand (d. h. Sequenzanteilabstand S'.3) zwischen den Pulsen sich erhöht, vorzugsweise verdoppelt, insbesondere durch eine Umschaltung zwischen wenigstens oder genau zwei Phasenlagen des Signals S' bei jedem Phasensprung P.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 2: Heckklappe
- 3: Stoßfänger
- 4: Türgriff
- 8: Benutzer
- 9: Körperteil, Aktivierungsmittel
- 10: Anordnung, Schaltungsanordnung
- 20: Sensorvorrichtung
- 20.1: Sensorelement, Sensorelektrode
- 20.2: Massepotential
- 50: Kontrollvorrichtung
- 50.1: Ansteuerungsvorrichtung, Mikrocontroller
- 50.2: Digital-Analog-Wandler
- 50.3: Anpassungsmittel
- 50.4: Halteanordnung
- 50.8: Datenspeicher
- 60: Schaltvorrichtung
- r: Receive-Pfad
- t: Transmit-Pfad
- t`: Zeit
- u: Übertragungspfad
- A: Amplitude
- CH: Haltekapazität
- CS: Sensorkapazität
- P: Phasensprung
- S: Schalterelement
- S': Auswertesequenz, Signal
- S'.1: Sequenzanteil
- S'.2: Sequenzanteilbreite
- S'.3: Sequenzanteilabstand

## Patentansprüche

1. Anordnung (10) für eine Auswertung bei einer kapazitiven Sensorvorrichtung (20) eines Fahrzeuges (1) zur Detektion einer Aktivierungshandlung beim Fahrzeug (1), wobei die kapazitative Sensorvorrichtung ein Annäherungssensor ist, mit
einer Kontrollvorrichtung (50) zum Betreiben wenigstens eines Sensorelements (20.1) mit wenigstens einer Auswertesequenz (S'), wobei
eine Ansteuerungsvorrichtung (50.1) der Kontrollvorrichtung (50) vorgesehen ist, um die Auswertesequenz (S') durch eine Anpassung zur Beeinflussung einer Störsignalsensitivität der Auswertung, vorzugsweise zur Beeinflussung des Spektrums der Auswertesequenz (S'), bereitzustellen,
wobei die Ansteuerungsvorrichtung (50.1) dazu ausgeführt ist, die Auswertesequenz (S') mit wiederholten Phasensprüngen (P) zu erzeugen, um wenigstens eine vorbestimmte Frequenz, vorzugsweise eine originäre Abtastfrequenz für das Sensorelement (20.1), bei der Auswertesequenz (S') abzuschwächen,
wobei wenigstens ein Schalterelement (S) mit der Ansteuerungsvorrichtung (50.1) verbunden ist, um wiederholt und in Abhängigkeit von der Anpassung, nämlich in Abhängigkeit von Phasensprüngen (P), durch die Ansteuerungsvorrichtung (50.1) geschaltet zu werden, um so einen Ladungstransport zwischen dem Sensorelement (20.1) und der Kontrollvorrichtung (50) gemäß der Auswertesequenz (S') durchzuführen,
wobei die Auswertesequenz (S') zumindest teilweise durch das Schalten des Schalterelements (S) bereitstellbar ist,
wobei die Kontrollvorrichtung (50) eine Halteanordnung (50.4) aufweist, welche über das Schalterelement (S) mit einem Übertragungspfad (u) zum Sensorelement (20.1) verbunden ist, um mittels der Auswertesequenz (S') eine Umladung der im Sensorelement (20.1) gespeicherten Ladung zur Halteanordnung (50.4) durchzuführen, und um eine veränderliche Kapazität des Sensorelements (20.1) anhand der Umladung auszuwerten,
wobei die Halteanordnung (50.4) einen Integrator aufweist.

2. Anordnung (10) nach Anspruch 1,
**dadurch gekennzeichnet,**
**dass** die Anpassung als Phasenmodulation ausgeführt ist, sodass vorzugsweise die Auswertesequenz (S') mit wiederholten Phasensprüngen (P) bereitstellbar ist.

3. Anordnung (10) nach einem der vorhergehenden Ansprüche,
**dadurch gekennzeichnet,**
**dass** die Anpassung als eine, insbesondere zeitliche, Anpassung von Sequenzanteilen (S'.1) der Auswertesequenz (S'), vorzugsweise einer Sequenzanteilbreite (S'.2) und/oder eines Sequenzanteilabstands (S'.3), ausgeführt ist,
und/oder dass die Anpassung als eine Phasenumtastung, vorzugsweise als eine binäre Phasenumtastung oder eine Quadraturphasenumtastung oder eine Phasenumtastung mit wenigstens zwei oder wenigstens vier Phasenzuständen, ausgeführt ist.

4. Anordnung (10) nach einem der vorhergehenden Ansprüche,
**dadurch gekennzeichnet,**
**dass** die Ansteuerungsvorrichtung (50.1) dazu ausgeführt ist, die Auswertesequenz (S') mit zumindest teilweise unterschiedlich breit und/oder unterschiedlich beabstandet ausgegebenen Sequenzanteilen (S'.1), vorzugsweise Pulsen, bevorzugt Rechteck-Pulsen, bereitzustellen.

5. Anordnung (10) nach einem der vorhergehenden Ansprüche,
**dadurch gekennzeichnet,**
**dass** wenigstens ein Schalterelement (S) mit einem Übertragungspfad (u) zum Sensorelement (20.1) verbunden ist, um wiederholt das Sensorelement (20.1) über den Übertragungspfad (u) abwechselnd mit einem Transmit-Pfad (t) zur Aufladung des Sensorelements (20.1) und mit einem Receive-Pfad (r) zur Umladung einer Ladung vom Sensorelement (20.1) zu verbinden, wobei zumindest die Umladung mit der Auswertesequenz (S') durchführbar ist.

6. Anordnung (10) nach einem der vorhergehenden Ansprüche,
**dadurch gekennzeichnet,**
**dass** die Kontrollvorrichtung (50) dazu ausgeführt ist, das Betreiben, insbesondere die Auswertung, des Sensorelements (20.1) frequenzsensitiv durchzuführen, wobei durch die Anpassung die Störsignalsensitivität verringerbar ist, und vorzugsweise gleichzeitig eine Bandbreite der Frequenzsensitivität erhöhbar ist, wobei bevorzugt die Störsignalsensitivität eine frequenzabhängige Störanfälligkeit für externe Signale bestimmt,
und/oder dass die Ansteuerungsvorrichtung (50.1) ein Anpassungsmittel (50.3) aufweist, um die Auswertesequenz (S') als Signal (S') mit zeitlich aufeinanderfolgenden Pulsen,
insbesondere in Rechteck- oder Sinusform, zu erzeugen, wobei durch die Anpassung, vorzugsweise durch wiederholte Phasensprünge (P), sich eine Pulsbreite vereinzelter Pulse oder vereinzelt ein Abstand zwischen den Pulsen sich erhöht, vorzugsweise verdoppelt, insbesondere durch eine Umschaltung zwischen wenigstens oder genau zwei Phasenlagen des Signals (S') bei jedem Phasensprung (P).

7. Anordnung (10) nach einem der vorhergehenden Ansprüche,
**dadurch gekennzeichnet,**
**dass** die Auswertesequenz (S') während des Betreibens durchgehend mittels Phasensprüngen (P) phasenmoduliert bereitstellbar ist, vorzugsweise mittels einer binären Phasenumtastung oder einer Quadraturphasenumtastung oder einer Phasenumtastung mit wenigstens zwei oder wenigstens vier Phasenzuständen.

8. Anordnung (10) nach einem der vorhergehenden Ansprüche,
**dadurch gekennzeichnet,**
**dass** ein Anpassungsmittel (50.3) vorgesehen ist, welches eine Information über die Anpassung aufweist, und vorzugsweise eine Information über Abstände der Phasensprünge (P) aufweist, um die Phasensprünge (P) äquidistant in vordefinierten Abständen durchzuführen,
und/oder dass ein Anpassungsmittel (50.3) vorgesehen ist, welches eine Information über Abstände von Phasensprüngen (P) bei der Anpassung aufweist, um die Phasensprünge (P) in unregelmäßigen und/oder pseudozufälligen, vordefinierten Abständen durchzuführen,
und/oder dass ein Anpassungsmittel (50.3) vorgesehen ist, vorzugsweise ein Zufallszahlengenerator, um Phasensprünge (P) bei der Anpassung in zufälligen Abständen durchzuführen.

9. Verfahren zum Betreiben eines Sensorelements (20.1) für eine Auswertung bei einer kapazitiven Sensorvorrichtung (20) eines Fahrzeuges (1) zur Detektion einer Aktivierungshandlung beim Fahrzeug (1), wobei die kapazitative Sensorvorrichtung ein Annäherungssensor ist,
**wobei die nachfolgenden Schritte durchgeführt werden:**
- Durchführen mehrerer Umladevorgänge bei dem Sensorelement (20.1),
- Durchführen einer Auswertung, insbesondere einer veränderlichen Kapazität des Sensorelements (20.1), anhand der Umladevorgänge, um eine Umgebung des Sensorelements (20.1) zu überwachen,
wobei die Umladevorgänge mit einer Auswertesequenz (S') durchgeführt werden, welche eine Anpassung, nämlich wiederholte Phasensprünge (P), zur Beeinflussung einer Störsignalsensitivität der Auswertung aufweist,
wobei die Umladevorgänge jeweils einen Übertragungsvorgang zum Aufladen des Sensorelements (20.1) und einen Empfangsvorgang zum Übertragen einer Ladung des Sensorelements (20.1) an eine Halteanordnung (50.4), nämlich eine Integratoranordnung (50.4), aufweisen, wobei durch die Anpassung, nämlich durch die Phasensprünge (P), die Übertragungs- und/oder Empfangsvorgänge mit unterschiedlichen Abständen zueinander durchgeführt werden.

10. Verfahren nach dem vorhergehenden Anspruch,
**dadurch gekennzeichnet,**
**dass** zur Bereitstellung der Auswertesequenz (S') ein Ursprungssignal, vorzugsweise ein Rechteck- oder Sinussignal, durch die Anpassung angepasst wird, vorzugsweise phasenmoduliert wird, besonders bevorzugt durch eine Ansteuerungsvorrichtung (50.1) einer Kontrollvorrichtung (50).

11. Verfahren nach einem der vorhergehenden Ansprüche,
**dadurch gekennzeichnet,**
**dass** eine Anordnung (10) nach einem der vorhergehenden Ansprüche betrieben wird.

12. Computerprogrammprodukt, umfassend Befehle, die bei der Ausführung durch eine Ansteuerungsvorrichtung (50.1) diese veranlassen, die Schritte eines Verfahrens nach einem der vorhergehenden Ansprüche auszuführen.

13. Computerlesbares Medium, auf welchem das Computerprogrammprodukt nach dem vorhergehenden Anspruch gespeichert ist.

## Claims

1. Arrangement (10) for an evaluation in a capacitive sensor device (20) of a vehicle (1) for detecting an activation action in the vehicle (1), the capacitive sensor device being a proximity sensor, having
a control device (50) for operating at least one sensor element (20.1) with at least one evaluation sequence (S'), wherein
an actuation device (50.1) of the control device (50) is provided in order to provide the evaluation sequence (S') by means of an adaptation for influencing an interference signal sensitivity of the evaluation, preferably for influencing the spectrum of the evaluation sequence (S'),
wherein the actuation device (50.1) is designed to generate the evaluation sequence (S') with repeated phase jumps (P) in order to attenuate at least one predetermined frequency, preferably an original sampling frequency for the sensor element (20.1), in the evaluation sequence (S'),
wherein at least one switch element (S) is connected to the actuation device (50.1) to be switched repeatedly and in dependence on the adaptation, namely in dependence on phase jumps (P), by the actuation device (50.1) so as to perform a charge transport between the sensor element (20.1) and the control device (50) in accordance with the evaluation sequence (S'),
whereby the evaluation sequence (S') can be provided at least in part by switching the switch element (S),
wherein the control device (50) has a holding arrangement (50.4) which is connected via the switch element (S) to a transmission path (u) to the sensor element (20.1) in order to carry out a recharging of the charge stored in the sensor element (20.1) to the holding arrangement (50.4) by means of the evaluation sequence (S'), and in order to evaluate a variable capacitance of the sensor element (20.1) on the basis of the recharging,
wherein the holding arrangement (50.4) comprises an integrator.

2. Arrangement (10) according to claim 1,
**characterized in that**
the adaptation is implemented as phase modulation, so that the evaluation sequence (S') can preferably be provided with repeated phase jumps (P).

3. Arrangement (10) according to one of the preceding claims,
**characterized in that**
the adaptation is implemented as an adaptation, in particular a temporal adaptation, of sequence components (S'.1) of the evaluation sequence (S'), preferably a sequence component width (S'.2) and/or a sequence component spacing (S'.3),
and/or that the adaptation is implemented as a phase shift keying, preferably as a binary phase shift keying or a quadrature phase shift keying or a phase shift keying with at least two or at least four phase states.

4. Arrangement (10) according to one of the preceding claims,
**characterized in that**
the actuation device (50.1) is designed to provide the evaluation sequence (S') with sequence components (S'.1), preferably pulses, preferably rectangular pulses, which are at least partially output with different widths and/or different spacing.

5. Arrangement (10) according to one of the preceding claims,
**characterized in that**
at least one switch element (S) is connected to a transmission path (u) to the sensor element (20.1) in order to repeatedly connect the sensor element (20.1) via the transmission path (u) alternately to a transmit path (t) for charging the sensor element (20.1) and to a receive path (r) for recharging a charge from the sensor element (20.1), it being possible to carry out at least the recharging with the evaluation sequence (S').

6. Arrangement (10) according to one of the preceding claims,
**characterized in that**
the control device (50) is designed to perform the operation, in particular the evaluation, of the sensor element (20.1) in a frequency-sensitive manner, wherein the interference signal sensitivity can be reduced by the adaptation, and preferably a bandwidth of the frequency sensitivity can be increased at the same time, wherein preferably the interference signal sensitivity determines a frequency-dependent susceptibility to interference for external signals,
and/or that the actuation device (50.1) has a matching means (50.3) in order to generate the evaluation sequence (S') as a signal (S') with pulses following one another in time, in particular in rectangular or sinusoidal form, a pulse width of individual pulses or an interval between the pulses being increased, preferably doubled, by the adaptation, preferably by repeated phase jumps (P), in particular by a switchover between at least or exactly two phase positions of the signal (S') with each phase jump (P).

7. Arrangement (10) according to one of the preceding claims,
**characterized in that**
the evaluation sequence (S') can be provided continuously phase-modulated during operation by means of phase jumps (P), preferably by means of binary phase shift keying or quadrature phase shift keying or phase shift keying with at least two or at least four phase states.

8. Arrangement (10) according to one of the preceding claims,
**characterized in that**
a matching means (50.3) is provided, which has information about the matching, and preferably has information about the intervals between the phase jumps (P), in order to carry out the phase jumps (P) equidistantly at predefined intervals,
and/or **in that** a matching means (50.3) is provided, which has information about intervals of phase jumps (P) during the matching in order to carry out the phase jumps (P) at irregular and/or pseudo-random, predefined intervals,
and/or **in that** a matching means (50.3) is provided, preferably a random number generator, in order to carry out phase jumps (P) during the matching at random intervals.

9. Method for operating a sensor element (20.1) for an evaluation in a capacitive sensor device (20) of a vehicle (1) for detecting an activation action in the vehicle (1), wherein the capacitive sensor device is a proximity sensor,
**whereby the following steps are carried out:**
- Carry out several recharging processes at the sensor element (20.1),
- Performing an evaluation, in particular of a variable capacitance of the sensor element (20.1), on the basis of the recharging processes in order to monitor an environment of the sensor element (20.1),
whereby the recharging processes are carried out with an evaluation sequence (S') which has an adaptation, namely repeated phase jumps (P), for influencing an interference signal sensitivity of the evaluation,
the recharging processes each having a transmission process for charging the sensor element (20.1) and a reception process for transmitting a charge of the sensor element (20.1) to a holding arrangement (50.4), namely an integrator arrangement (50.4), the transmission and/or reception processes being carried out at different distances from one another as a result of the adaptation, namely as a result of the phase jumps (P).

10. Method according to the preceding claim,
**characterized in that**
to provide the evaluation sequence (S'), an original signal, preferably a square-wave or sinusoidal signal, is adapted by the adaptation, preferably phase-modulated, particularly preferably by an actuation device (50.1) of a control device (50).

11. A method according to any one of the preceding claims,
**characterized in that**
an arrangement (10) according to one of the preceding claims is operated.

12. A computer program product comprising instructions which, when executed by an actuation device (50.1), cause it to perform the steps of a method according to any one of the preceding claims.

13. A computer-readable medium on which the computer program product according to the preceding claim is stored.

## Revendications

1. Dispositif (10) pour une évaluation dans un dispositif de détection capacitif (20) d'un véhicule (1) pour la détection d'une action d'activation dans le véhicule (1), le dispositif de détection capacitif étant un capteur de proximité, avec
un dispositif de contrôle (50) pour faire fonctionner au moins un élément de capteur (20.1) avec au moins une séquence d'évaluation (S'), dans lequel
un dispositif de commande (50.1) du dispositif de contrôle (50) est prévu pour mettre à disposition la séquence d'évaluation (S') par une adaptation pour influencer une sensibilité aux signaux parasites de l'évaluation, de préférence pour influencer le spectre de la séquence d'évaluation (S'),
dans lequel le dispositif de commande (50.1) est adapté pour générer la séquence d'évaluation (S') avec des sauts de phase répétés (P) afin d'atténuer au moins une fréquence prédéterminée, de préférence une fréquence d'échantillonnage originale pour l'élément de capteur (20.1), dans la séquence d'évaluation (S'),
dans lequel au moins un élément de commutation (S) est connecté au dispositif de commande (50.1) pour être commuté de manière répétée et en fonction de l'adaptation, à savoir en fonction de sauts de phase (P), par le dispositif de commande (50.1), de manière à effectuer un transfert de charge entre l'élément de capteur (20.1) et le dispositif de contrôle (50) conformément à la séquence d'évaluation (S'),
la séquence d'évaluation (S') pouvant être fournie au moins partiellement par la commutation de l'élément de commutation (S),
le dispositif de contrôle (50) présentant un dispositif de maintien (50.4) qui est relié par l'intermédiaire de l'élément de commutation (S) à un chemin de transmission (u) vers l'élément de détection (20.1), afin d'effectuer au moyen de la séquence d'évaluation (S') un transfert de la charge stockée dans l'élément de détection (20.1) vers le dispositif de maintien (50.4), et afin d'évaluer une capacité variable de l'élément de détection (20.1) au moyen du transfert,
le dispositif de maintien (50.4) comportant un intégrateur.

2. Dispositif (10) selon la revendication 1,
**caractérisé en ce que**
l'adaptation est réalisée sous forme de modulation de phase, de sorte que la séquence d'évaluation (S') peut de préférence être mise à disposition avec des sauts de phase (P) répétés.

3. Dispositif (10) selon l'une quelconque des revendications précédentes,
**caractérisé en ce que**
l'adaptation est réalisée sous la forme d'une adaptation, notamment temporelle, de parties de séquence (S'.1) de la séquence d'évaluation (S'), de préférence d'une largeur de partie de séquence (S'.2) et/ou d'une distance de partie de séquence (S'.3),
et/ou **en ce que** l'adaptation est réalisée sous la forme d'une modulation par déplacement de phase, de préférence une modulation par déplacement de phase binaire ou une modulation par déplacement de phase en quadrature ou une modulation par déplacement de phase avec au moins deux ou au moins quatre états de phase.

4. Dispositif (10) selon l'une quelconque des revendications précédentes,
**caractérisé en ce que**
le dispositif de commande (50.1) est conçu pour fournir la séquence d'évaluation (S') avec des parties de séquence (S'.1), de préférence des impulsions, de préférence des impulsions rectangulaires, émises au moins en partie avec une largeur différente et/ou un espacement différent.

5. Dispositif (10) selon l'une quelconque des revendications précédentes,
**caractérisé en ce qu'**
au moins un élément de commutation (S) est relié à un chemin de transmission (u) vers l'élément de capteur (20.1) pour relier de manière répétée l'élément de capteur (20.1) par le chemin de transmission (u) alternativement à un chemin d'émission (t) pour charger l'élément de capteur (20.1) et à un chemin de réception (r) pour transférer une charge de l'élément de capteur (20.1), au moins le transfert pouvant être effectué avec la séquence d'évaluation (S').

6. Dispositif (10) selon l'une quelconque des revendications précédentes,
**caractérisé en ce que**
le dispositif de contrôle (50) est réalisé pour effectuer le fonctionnement, en particulier l'évaluation, de l'élément de capteur (20.1) de manière sensible à la fréquence, l'adaptation permettant de réduire la sensibilité aux signaux parasites et, de préférence, d'augmenter en même temps une largeur de bande de la sensibilité à la fréquence, la sensibilité aux signaux parasites déterminant de préférence une sensibilité aux parasites dépendant de la fréquence pour des signaux externes,
et/ou **en ce que** le dispositif de commande (50.1) comprend un moyen d'adaptation (50.3) pour générer la séquence d'évaluation (S') sous forme de signal (S') avec des impulsions qui se succèdent dans le temps, en particulier sous forme rectangulaire ou sinusoïdale, l'adaptation, de préférence par des sauts de phase (P) répétés, augmentant, de préférence doublant, une largeur d'impulsion d'impulsions individuelles ou un écart entre les impulsions individuelles, en particulier par une commutation entre au moins ou exactement deux positions de phase du signal (S') à chaque saut de phase (P).

7. Dispositif (10) selon l'une quelconque des revendications précédentes,
**caractérisé en ce que**
la séquence d'évaluation (S') peut être mise à disposition pendant le fonctionnement en étant modulée en phase de manière continue au moyen de sauts de phase (P), de préférence au moyen d'une modulation par déplacement de phase binaire ou d'une modulation par déplacement de phase en quadrature ou d'une modulation par déplacement de phase avec au moins deux ou au moins quatre états de phase.

8. Dispositif (10) selon l'une quelconque des revendications précédentes,
**caractérisé en ce qu'**
il est prévu un moyen d'adaptation (50.3) qui présente une information sur l'adaptation, et de préférence une information sur les intervalles des sauts de phase (P), afin d'effectuer les sauts de phase (P) de manière équidistante à des intervalles prédéfinis,
et/ou **en ce qu'**il est prévu un moyen d'adaptation (50.3) qui présente une information sur des intervalles de sauts de phase (P) lors de l'adaptation, afin d'effectuer les sauts de phase (P) à des intervalles irréguliers et/ou pseudo-aléatoires prédéfinis,
et/ou **en ce qu'**il est prévu un moyen d'adaptation (50.3), de préférence un générateur de nombres aléatoires, pour effectuer des sauts de phase (P) lors de l'adaptation à des intervalles aléatoires.

9. Procédé de fonctionnement d'un élément de capteur (20.1) pour une évaluation dans un dispositif de détection capacitif (20) d'un véhicule (1) pour la détection d'une action d'activation dans le véhicule (1), le dispositif de détection capacitif étant un capteur de proximité,
**en effectuant les étapes suivantes :**
- Effectuer plusieurs opérations de transbordement sur l'élément de capteur (20.1),
- Effectuer une évaluation, en particulier d'une capacité variable de l'élément de capteur (20.1), à l'aide des opérations de transbordement, afin de surveiller un environnement de l'élément de capteur (20.1),
les opérations de transbordement étant effectuées avec une séquence d'évaluation (S') qui présente une adaptation, à savoir des sauts de phase répétés (P), pour influencer une sensibilité de l'évaluation aux signaux parasites,
les opérations de transfert présentant chacune une opération de transmission pour charger l'élément de capteur (20.1) et une opération de réception pour transmettre une charge de l'élément de capteur (20.1) à un dispositif de maintien (50.4), à savoir un dispositif intégrateur (50.4), l'adaptation, à savoir les sauts de phase (P), permettant d'effectuer les opérations de transmission et/ou de réception à des distances différentes les unes des autres.

10. Procédé selon la revendication précédente,
**caractérisé en ce que**
pour fournir la séquence d'évaluation (S'), un signal d'origine, de préférence un signal rectangulaire ou sinusoïdal, est adapté par l'adaptation, de préférence est modulé en phase, de manière particulièrement préférée par un dispositif de commande (50.1) d'un dispositif de contrôle (50).

11. Procédé selon l'une quelconque des revendications précédentes,
**caractérisé en ce qu'**
on fait fonctionner un dispositif (10) selon l'une des revendications précédentes.

12. Produit programme d'ordinateur comprenant des instructions qui, lorsqu'elles sont exécutées par un dispositif de commande (50.1), amènent celui-ci à exécuter les étapes d'un procédé selon l'une quelconque des revendications précédentes.

13. Support lisible par ordinateur sur lequel est stocké le produit programme d'ordinateur selon la revendication précédente.
